**Europäisches Patentamt**

**European Patent Office**

**Office européen des brevets**

(11) Numéro de publication: **0 002 999**

**B1**

(12) **FASCICULE DE BREVET EUROPEEN**

(45) Date de publication du fascicule du brevet: **10.10.84**

(51) Int. Cl.³: **G 03 F 1/00, G 03 F 7/02**

(21) Numéro de dépôt: **78430023.8**

(22) Date de dépôt: **08.12.78**

(54) Procédé de formation d'une couche de masquage sur un substrat pour constituer un masque.

(30) Priorité: **30.12.77 US 866191**

(43) Date de publication de la demande:
**11.07.79 Bulletin 79/14**

(45) Mention de la délivrance du brevet:
**10.10.84 Bulletin 84/41**

(84) Etats contractants désignés:
**DE FR GB**

(56) Documents cités:
**AT-B- 333 795**
**FR-A-1 530 266**
**GB-A- 780 218**
**US-A-2 702 243**
**US-A-3 201 239**
**US-A-3 666 473**
**US-A-3 884 696**

**IBM TECHNICAL DISCLOSURE BULLETIN, vol. 13, no. 2, juillet 1970, New York, W.M. MOREAU et al.: "Positive resist systems", page 297**
**IBM TECHNICAL DISCLOSURE BULLETIN, vol. 14, no. 1, janvier 1971, New York, J.A. HARROCKS: "Making photolitographic masks", page 106**

(73) Titulaire: **International Business Machines Corporation**
**Old Orchard Road**
**Armonk, N.Y. 10504 (US)**

(72) Inventeur: **Lapadula, Constantino**
**Steiner Drive RFD 1**
**Mahopac New York 10541 (US)**
Inventeur: **Lin, Burn Jeng**
**Valley Pond Road**
**Katonah New York 10536 (US)**

(74) Mandataire: **Klein, Daniel Jacques Henri**
**Compagnie IBM France Département de Propriété Industrielle**
**F-06610 La Gaude (FR)**

(56) Documents cités:
**IBM TECHNICAL DISCLOSURE BULLETIN, vol. 21, no. 5, octobre 1978, New York, B.J. LIN: "Portable intimately contacted mask", page 2133**
**IBM TECHNICAL DISCLOSURE BULLETIN, vol. 14, no. 10, Mars 1972, New York, M.W. MacINTYRE et al.: "Semitransparent mask for integrated circuit production", page 2878**

Courier Press, Leamington Spa, England.

## Description

Domain de l'invention

La présente invention concerne les procédés de fabrication de couches de masquage ou de masques, capable de résister au décapage et, plus particulièrement, un procédé permettant d'utiliser directement une première couche exposée d'un matériau photorésistant comme masque pour exposer une seconde couche de matériau photorésistant. De telles couches de masquage capables de résister au décapage sont utiles lors de la fabrication des circuits intégrés.

Etat de la technique

En pareil cas, une couche d'un matériau photorésistant sensible aux radiations est déposée sur un substrat et exposée à une radiation actinique c'est-à-dire active pour le matériau considéré, constituée, par exemple, par une lumière visible ou ultraviolette par des rayons X, par une radiation nucléaire, nucléons, ou par des électrons. Les régions irradiées de la couche subissent une modification chimique qui les rend plus solubles (matériau photorésistant positif) ou moins solubles (matériau photorésistant négatif) que les régions non-irradiées. Un produit de développement est alors employé pour retirer de façon sélective les régions les plus solubles, qui sont les régions irradiées s'il s'agit d'un matériau photorésistant positif et les régions non irradiées s'il s'agit d'un matériau photorésistant négatif. Le substrat peut alors faire l'objet d'une étape de traitement sélectif, à travers des ouvertures ou des fenêtres réalisées dans le masque ou couche de masquage, par exemple un décapage ou un dépôt.

Les dimensions des dispositifs semiconducteurs affectant la vitesse de fonctionnement des circuits intégrés, de même que leur prix de revient initial et le coût de leur utilisation, on a cherché à diminuer les dimensions de leurs différents composants et à augmenter ainsi la densité d'assemblage ou d'intégration des composants intégrés. Cette diminution des dimensions est toutefois limitée par la précision avec laquelle des masques capables de résister au décapage, peuvent être fabriqués et alignés. Compte tenu du fait que certaines étapes de traitement, telles que des étapes de plaquage électrolytique, de décapage par ions réactifs et d'élimination ar décollement, appelée communément dans la littérature anglo-saxonne lift off) exigent l'emploi d'un masque relativement épais, deux facteurs importants seront donc la résolution et le rapport géométrique qui se définit comme le rapport de l'épaisseur du masque par la largeur de ligne minimum pratique pour cette épaisseur que l'on peut obtenir. Ces deux facteurs sont fonction, d'une part, du matériau photorésistant et de la radiation actinique choisis, et, d'autre part, du type et de la résolution du système d'exposition.

Le matériau photorésistant choisi est une résine phénol-formaldéhyde sensibilisée par un composé diazoïque, c'est un matériau photorésistant positif communément utilisé actuellement et qui comprend un polymère soluble dans les bases (après exposition) tel qu'une résine phénol-formaldéhyde de type novolak, et un composé photo-actif tel qu'un sensibilisateur constitué par l'ester de l'acide naphtoquinone-(1,2)-diazide sulfonique. Des matériaux photorésistants et des sensibilisateurs de ce type sont décrits, par exemple, dans les brevets des E.U.A. N° 3.046.118, 3.046.121, 3.106.465, 3.202.239, 3.666.473 et 4.007.047. Les matériaux photorésistants du type phénol-formaldéhyde sensibilisés par un composé diazoïque présentent une sensibilité élevée et une résolution inférieure au micron lorsque l'épaisseur de la couche du matériau est suffisamment faible pour que la diffraction et l'absorption ne limitent pas la résolution. Les couches de matériaux de ce type dont l'épaisseur est supérieure à un micron présentent un faible rapport géométrique et une résolution beaucoup plus réduite par suite des effets optiques de diffraction et d'absorption.

Lorsque l'exposition de ce matériau photorésistant est effectuée par projection optique, la profondeur de champ limite également la résolution et le rapport géométrique, à moins que la couche ne soit mince. Ce problème peut être évité en formant un faisceau étroit de photons et en commandant celui-ci au moyen d'un calculateur de manière à "écrire" directement la configuration déterminée désirée sur ladite couche, mais ce procédé est peu pratique car il nécessite la manipulation précise d'un système optique comportant des lentilles, ce qui prend beaucoup de temps et est incommode. On peut aussi remplacer le faisceau de photons par un faisceau électronique, mais la réflexion qui se produit alors, a également pour effet de limiter la résolution que l'on peut obtenir. L'exposition par contact permet d'éviter le problème afférent à la profondeur de champ, mais présente d'autres inconvénients; un effet, ce type d'exposition tend à rayer les masques dont la durée de vie est rendue faible, on doit alors utiliser des masques ayant une durée de vie supérieure à celle des masques prévus pour une exposition effectuée par projection optique. On peut aussi disposer la masque à proximité du matériau photorésistant, ce qui a pour effet de prolonger la durée de vie du masque, mais d'aggraver les effets de la diffraction. On peut réduire ces derniers dans une certaine mesure, en diminuant la longueur d'onde de la lumière employée aux fins de l'exposition, mais la sensibilité à la lumière et les caractéristiques d'absorption du matériau photorésistant imposent des limites à l'amélioration que l'on aurait pû ainsi attendre. En raison de ces différents problèmes, il s'est révélé peu pratique de réaliser des masques épais à partir d'une résine phénol-formaldéhyde sensibilisée par un composé diazoïque qui présente une résolution élevée.

Un autre type de matériau photorésistant positif communément employé se compose de certains polymères de méthacrylate d'alkyle qui peuvent être modifiés par des radiations. De tels matériaux sont décrits, par exemple, dans les brevets des E.U.A. Nos. 3 538 137, 3 934 057 et 3 984 582. Les polymères du méthacrylate d'alkyle, tel que le polyméthacrylate de méthyle, et les copolymères du méthacrylate de méthyle et du polyméthacrylate de méthyle sont généralement exposés à un mince faisceau d'électrons commandé par un calculateur, de façon à "écrire" directement sur la couche la configuration désirée. La résolution d'un tel matériau photorésistant n'est pas limitée par les effets de la diffraction, et la vitesse d'écriture en direct est suffisamment élevée pour être intéressante. Dans des couches minces, les techniques actuelles permettent d'obtenir une résolution correspondant à une fraction d'un micron. Toutefois, les rebondissements (ou dispersion) des électrons qui se produisent lorsqu'on dirige un faisceau électronique vers une couche épaisse de tels polymères, se traduisent par un médiocre rapport géométrique. Alors qu'une résolution de 0,5 micron peut être obtenue dans le cas d'une couche d'un tel matériau d'une épaisseur de 0,25 micron, cette résolution tombe à un micron environ des lors que l'épaisseur de la couche est de 0,4 micron.

D'autres radiations de forte énergie permettent également de modifier les polymères du méthacrylate d'alkyle. Les rayons X dans la gamme de 0,5 nm à 5 nm permettent d'obtenir des bords particulièrement bien définis et un rapport géométrique élevé. Cependant, une écriture directe au moyen de rayons X commandés par calculateur n'est pas pratique dans le contexte technique actuel, et l'exposition au moyen de rayons X par la technique de projection, n'est pas réalisable techniquement. Les rayons X permettent d'effecteur une exposition en mettant le masque en contact avec le matériau photorésistant ou en le disposant à proximité de ce dernier, cependant on ne dispose en fait d'aucun matériau permettant de réaliser des masques de qualité convenable. Une configuration en or sur du mylar a été utilisée aux fins d'une exposition par contact au moyen de rayons X, mais il est difficile de former une mince couche de mylar qui soit à la fois uniforme et dépourvue de défaut. Par ailleurs, les feuilles minces de mylar sont susceptibles de s'allonger, ce qui pose un nouveau problème en ce qui concerne le contrôle des dimensions.

Les couches de matériaux photorésistants constitués par des polymères de méthacrylate d'alkyl, peuvent être modifiées de façon sélective en les exposant à une lumière ultraviolette présentant une longueur d'onde inférieure a 300 nm comme il est connu du brevet GB—

A—780 218. Comme précédemment, l'écriture est directe mais peu pratique, cependant que l'exposition par projection limite la résolution dans les couches épaisses par suite de problèmes de profondeur de champ. Des masques d'exposition par contact peuvent être réalisés à partir de chrome, mais il est difficile d'obtenir des couches de chrome minces de façon uniforme sans formation de trous d'épingle. Par ailleurs, une couche de chrome ne peut pas être séparée du substrat sans endommager ce dernier. Si les masques de contact en chrome ont une durée de vie raisonnable, leur fabrication nécessite plusieurs étapes, y compris une étape de formation d'une couche de protection, capable de résister au décapage, sur la couche de chrome.

Pareille complexité n'est justifiée que si le masque est appelé à servir de nombreuses fois. Les masques en chrome posent un problème supplémentaire, car, du fait de leur Opacité, ils sont plus difficiles à aligner correctement que des masques transparents tels que ceux en oxyde de fer. Des masques semi-transparents utilisant une émulsion d'halogénure d'argent ne peuvent pas être employés du fait de la faible résolution qui résulte des grains importants de l'image. Les masques semi-transparents utilisant un colorant de visualisation de type diazoïque, ne sont pas d'un emploi commode car ils sont très difficiles à former correctement et à séparer du substrat sans endommager ce dernier. Par ailleurs, on ignore le comportement de tels masques dans la gamme de l'ultraviolet lointain.

Du brevet US—A—2 702 243 il est connu un procédé de formation d'un masque sur un substrat caractérisé en ce qu'il comporte les étapes suivantes:

(a) la formation sur ledit substrat, d'une première couche de masquage à partir d'une résine,

(b) la formation sur cette première couche d'une seconde couche selon une configuration désirée, à partir d'une résine sensible pour constituer un masque intermédiaire,

(c) transfert de la configuration du masque intermédiaire sur la couche de masquage par exposition à des radiations,

(d) élimination des parties exposées de la couche de masquage à l'aide d'un solvant approprié pour constituer un masque.

Exposé de la présente invention

L'un des avantages de la présente invention est donc de fournir un procédé pratique de fabrication d'un masque épais résistant au décapage et présentant un rapport géométrique et une résolution élevés.

Un autre avantage de l'invention est de réduire le nombre et la complexité des différentes étapes du procédé de fabrication.

Un autre avantage de l'invention est de fournir un procédé pratique de fabrication d'un masque épais résistant au décapage et présentant un rapport géométrique et une résolution élevés, lorsque ce masque doit être réalisé à un très petit nombre d'exemplaires ou même à un seul exemplaire.

Un autre avantage de l'invention est de fabriquer un masque épais résistant au décapage qui présente un rapport géométrique et une résolution élevés sans formation d'un masque de contact en chrome.

Un autre avantage de l'invention est de permettre une exposition par projection du matériau photorésistant sans que la profondeur de champ afférente à cette technique de projection limite le rapport géométrique et la résolution finalement obtenus.

Un autre avantage enfin de l'invention est d'utiliser une technique d'exposition optique du matériau photorésistant qui permette de réduire les effets de la diffraction sur le rapport géométrique et la résolution finalement obtenus.

Ces avantages et d'autres sont obtenus d'une façon très simple selon les modes particuliers de réalisation de l'invention en utilisant directement, comme masque intermédiaire, un matériau photorésistant du type phénol-formaldéhyde sensibilisé par un composé diazoïque. On a constaté que ce type de matériau, classique, était opaque au-dessous de 300 nm, ce qui correspond par contre à la gamme de sensibilité optique d'un autre matériau photorésistant courant, à savoir les polymères du méthacrylate d'alkyle. Il est donc possible d'employer une source lumineuse à spectre large comprenant l'ultraviolet lointain, pour exposer un matériau photorésistant sensible à ce dernier, tel qu'un polymère du méthacrylate d'alkyle, au travers d'un masque développé en un matériau photorésistant du type phénol-formaldéhyde sensibilisé par un composé diazoïque. La couche de ce dernier matériau peut être rendue suffisamment mince pour éviter les effets, qui limitent la résolution, produits par la diffraction de la lumière ou de la profondeur de champ. Par contre le matériau photorésistant en méthacrylate d'alkyle peut être rendu suffisamment épais pour rendre possible les étapes de traitement qui exigent l'emploi de couches épaisses de matériau photorésistant et un rapport géométrique élevé, sans pour autant perdre la résolution élevée qui résulte de l'utilisation de ladite couche mince et sans avoir à former de masque supplémentaire composé d'un autre matériau tel que le chrome.

Le procédé de l'invention comprend donc les étapes suivantes:

a) la formation sur ledit substrat d'une première couche de masquage à partir d'une résine sensible à des radiations de longueurs d'onde, inférieures à environ 260 nm,
b) la formation sur cette première couche d'une seconde couche selon une configuration désirée, à partir d'une résine sensible opaque à des radiations de longueurs d'onde inférieures à environ 300 nm, pour constituer un masque intermédiaire,
c) transfert de la configuration du masque intermédiaire sur la couche de masquage par exposition à des radiations, dont au moins une longueur d'onde est inférieure à 300 nm, et
d) élimination des parties exposées de la couche de masquage à l'aide d'un solvant approprié pour constituer un masque.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

Les figures 1A, 1B et 1C sont des coupes partielles illustrant différentes techniques de formation d'un masque photorésistant en matériau du type phénol-formaldéhyde sensibilisé par un composé diazoïque utilisable ultérieurement comme masque séparé à transmission pour la photo-exposition d'un autre couche.

La figure 2 est une coupe partielle d'un masque séparé en matériau du type phénol-formaldéhyde développé servant de masque de contact permettant d'exposer une couche d'un matériau photorésistant sensible à l'ultraviolet lointoin.

Les figures 3A, 3B et 3C sont des coupes partielles d'une réalisation de l'invention dans laquelle un masque intermédiaire en matériau du type phénol-formaldéhyde a été réalisé au-dessus d'une couche de matériau photorésistant sensible à l'ultraviolet lointoin.

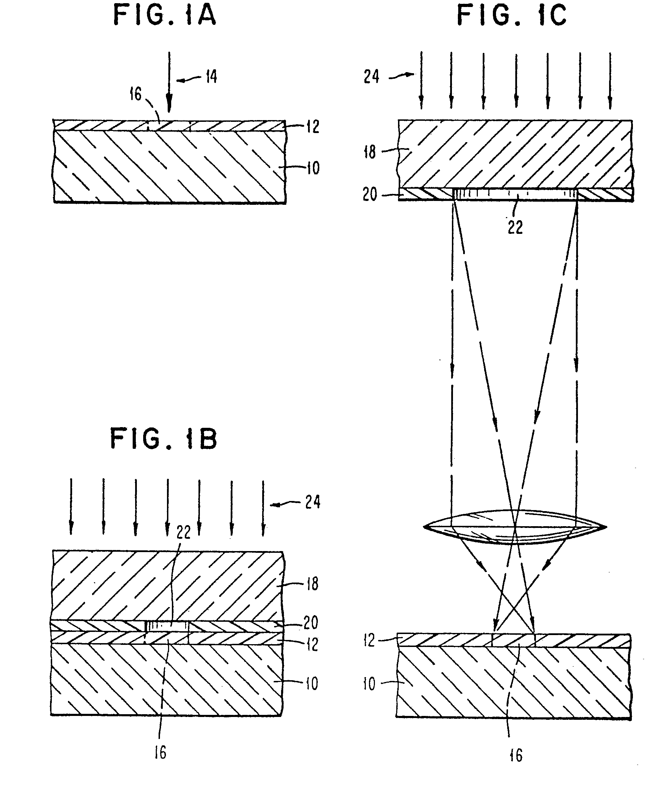

On a représenté sur les figures 1A, 1B et 1C trois façons différentes d'exposer une couche 12 d'un matériau photorésistant du type phénol-formaldehyde sensibilisé par un composé diazoïque. La couche 12 est déposée sur un substrat 10 par un procédé connu quelconque, par exemple par immersion, recouvrement ou centrifugation. Ainsi qu'on le verra plus loin, le substrat 10 doit être capable de transmettre l'ultraviolet lointain. Du quartz peut être utilisé à cette fin. La couche 12 peut être constituée par n'importe lequel des nombreux matériaux photorésistants positifs disponibles dans le commerce et se composer d'une résine phénol-formaldéhyde soluble dans les bases de type novolak et d'un composé photo-actif sensibilisateur contenant des groupes diazoïques et cétoniques à des positions adjacentes sur la molécule. De telles résines et de tels sensibilisateurs sont décrits à titre d'exemple dans les brevets précités. Une résine phénol-formaldéhyde convenable est la métacrésol-formaldéhyde, et un sensibilisateur convenable est un ester de l'acide naphtoquinone-1,2-diazide sulfonique, par exemple l'ester de l'acide 1-oxo-2 diazo naphtalène 5 sulfonique du 2,3,4-trihydroxybenzophénone. De tels matériaux

photorésistants sont commercialisés, par exemple, par la firme Shipley sous les appelations AZ-1350, AZ-1350B, AZ-1350H, AZ-1350J, AZ-2400 et AZ-111. Les matériaux Kodak 809, Polychrome PC-129 et Nagase KTI seraient du même type.

La couche 12 peut être exposée en employant une technique connue quelconque, par exemple par écriture directe au moyen d'un faisceau mince de photons ou d'électrons 14 commandé par calculateur (figure 1A), ou par exposition à une radiation actinique 24 à travers un masque composé d'une couche de masquage 20 disposée sur un substrat transparent 18 (figure 1B) et comportant une ouverture désirée 22. Une exposition effectuée au moyen d'une lumière réfléchie ou transmise (voir figure 1C) peut être utilisée à la place de la technique par contact de la figure 1B. Une fois exposée par l'une quelconque de ces techniques dans les régions désirées (schématiquement représentées ici par la région 16), la couche 12 est développée dans une solution de développement basique de manière à retirer de façon sélective ces régions, formant ainsi une image en relief (schématiquement représentée sur la ligne 2 par l'ouverture 17). Ce masque en matériau du type phénol-formaldéhyde resultant sera ensuite utilisé soit sous la forme d'une couche de masquage 12 soit sous la forme d'un masque 10+12, utilisé pour exposer une autre couche de matériau photorésistant 28 appliqué sur un substrat 26.

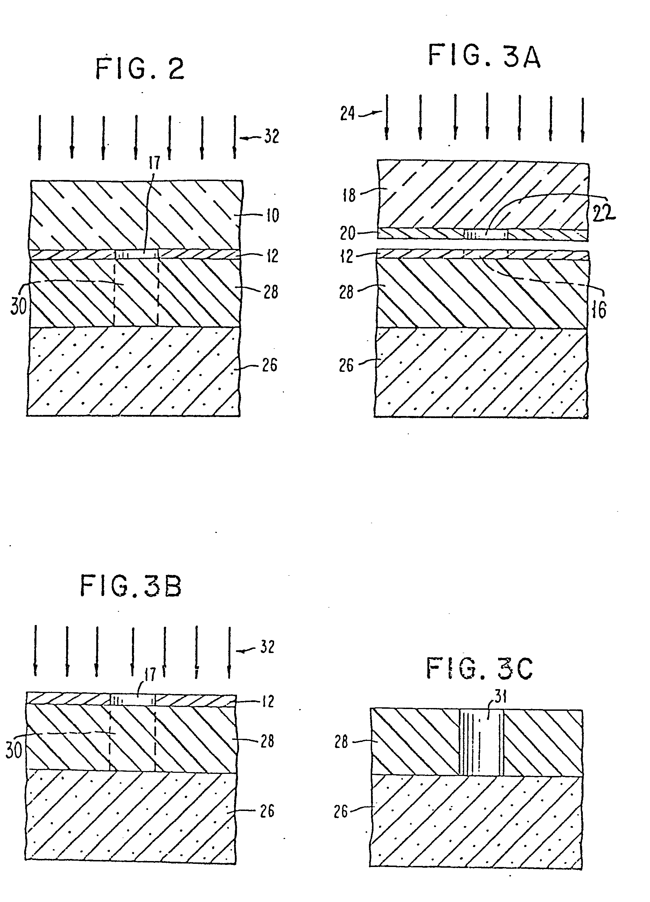

La couche 28 peut se composer d'un matériau photorésistant quelconque sensible à l'ultraviolet lointain tel qu'un ester homologue inférieur de l'acide alkyl méthacrylique, par exemple du polyméthacrylate de méthyle, ou d'un copolymère du méthacrylate de méthyle et du polyméthacrylate de méthyle. Certains matériaux photorésistants du type phénol-formaldéhyde sensibilisés par un composé diazoïque sont également sensibles à l'ultraviolet lointain, par exemple le matériau AZ-2400 commercialisé par Shipley. Le masque 12 va être utilisé (figure 2) pour exposer la couche 28 à l'ultraviolet lointain de façon classique, soit par la technique de contact, soit par la technique de proximité, soit enfin par la technique de projection, dans ce dernier cas si une profondeur de champ suffisante peut être obtenue on si le système optique transmet l'ultraviolet lointain. On remarque que si le masque 12 est utilisé dans un mode réfléchissant aux fins d'une exposition par projection, une couche réfléchissante, composée par exemple, d'aluminium ou de chrome, doit être disposée entre le matériau photorésistant et le substrat.

On a en effet constaté que le matériau de la couche 12 est effectivement opaque à la lumière si la longueur d'onde de celle-ci est inférieure à 300 nm environ, alors qu'un matériau photorésistant en méthacrylate d'alkyle n'est sensible qu'à une lumière dont la longueur d'onde est inférieure à 260 nm environ. Ainsi, lorsque la couche 28 se compose d'un méthacrylate d'alkyle, la lumière 32 peut provenir d'une source lumineuse quelconque comportant une composante ultraviolette d'une longueur d'onde inférieure à 260 nm environ. La lumière de longueur d'onde supérieure à 300 nm qui traverse le matériau du masque 12 n'affecte pas la couche 28 si cette dernière n'est sensible qu'à la lumière dont la longueur d'onde est inférieure à 300 nm, comme c'est le cas du méthacrylate d'alkyle. Etant donné que le matériau AZ-2400 est également sensible à la lumière dont la longueur d'onde est supérieure à 300 nm, la source lumineuse 32 peut ne pas comporter de composante actinique supérieure à 300 nm lorsque la couche 28 se compose de ce type de matériau photorésistant. La lumière dont la longueur d'onde est inférieure à 200 nm est absorbée par l'air, mais peut être transmise dans le vide jusqu'à 100 nm. Des sources de lumière ultraviolette fonctionnant dans le vide sont aisément disponibles, mais l'exposition du méthacrylate d'alkyle doit être effectuée dans le vide. D'autre part, étant donné que le quartz absorbe la lumière dont la longueur d'onde est inférieure à 180 nm environ, l'exposition effectuée dans la gamme de longueurs d'onde dans laquelle la lumière ultraviolette peut être transmise dans le vide nécessitera généralement l'emploi du procédé illustré sur les figures 3A, 3B et 3C, qui n'exige pas de substrat pour la couche du matériau photorésistant du type phénol-formaldéhyde. Après avoir été exposée au travers du masque 12, (figure 2), la couche 28 est développée de manière à obtenir sur le substrat 26 une couche de masquage résistant au décapage. La couche 12 doit être suffisamment mince pour permettre d'obtenir la résolution optimum que la couche 28 peut présenter, quelle que soit l'épaisseur requise aux fins des traitements ultérieurs.

Un mode de réalisation conforme à la présente invention est illustré sur les figures 3A, 3B et 3C. Dans cette réalisation, la couche de matériau photorésistant 12 est directement déposée sur la couche 28 (figure 3A) qui est sensible à l'ultraviolet lointain. La couche 12 est ensuite exposée au moyen d'une technique appropriée quelconque, par exemple grâce à un masque de proximité 18—20 représenté sur la figure 3A, puis développée ce qui crée l'ouverture 17 (figure 3B) et de nouveau exposée à la lumière 32 qui comporte des composantes correspondant à l'ultraviolet lointain. Une région 30 est ainsi exposée à travers l'ouverture 17 et est ensuite développée, ce qui permet d'obtenir l'ouverture 31 (figure 3C). La couche 12 peut être alors retirée si cela est désiré (figure 3C).

Expérience I
Utilisation du matériau du type phénol-formaldéhyde sensibilisé pour masque séparé à transmission
Une couche de matériau photorésistant Shipley AZ-1350J d'une épaisseur de 0,2 micron a été déposée sur un substrat en quartz, puis exposée au travers d'un masque en chrome comportant une configuration de lignes de différentes largeurs, en utilisant la technique d'exposition par contact de la figure 1B, et une lumière fournie par une lampe à arc au xénon-mercure. La couche de matériau photorésistant a ensuite été développée dans un produit de développement Shipley convenant à ce type de matériau de manière à former un masque présentant des lignes verticales bien définies de 0,5 micron.

Un autre substrat a ensuite été recouvert d'une couche de 1,6 micron d'un matériau photorésistant constitué par du polyméthacrylate de méthyle (PMMA) commercialisé par la firme Du Pont sous l'appellation "Elvacite 2041". Cette couche a été mise en contact avec le masque représenté sur la figure 2. Le masque a ensuite été éclairé au moyen de la lampe à arc et la couche de PMMA développée dans de la méthylisobutylcétone. On a ainsi obtenu des parois verticales bien définies dans la couche de PMMA d'une épaisseur de 1,6 microns avec une résolution de 0,5 micron.

Expérience II

Lors de cette expérience, la couche de PMMA a été directement revêtue du matériau photorésistant AZ, et exposée au moyen d'une lampe au deutérium. Les autres conditions dans lesquelles l'expérience s'est déroulée étaient les mêmes que dans le cas de l'utilisation du matériau du type phénol-formaldéhyde sensibilisé pour masque séparé à transmission et des résultats analogues ont été obtenus. Des parois verticales bien définies ont été obtenues dans la couche de PMMA d'une épaisseur de 1,6 micron avec une résolution de 0,5.

Expérience III

Cette expérience s'est déroulée dans les mêmes conditions que la précédente, à l'exception du fait que la couche de matériau photorésistant AZ avait une épaisseur de 0,8 micron et que du chlorobenzène a été employé pour développer la couche de PMMA. Le matériau de développement n'étant pas le même que précédemment, le masque en matériau AZ n'a pas été totalement dissous alors qu'il l'avait été lors de l'expérience II. Les lignes obtenues dans la couche de matériau photorésistant en matériau AZ, de 0,8 micron présentaient un profil trapézoïdal, cependant, ces lignes présentaient des parois verticales bien définies dans la couche de PMMA.

Bien que l'on ait décrit dans ce qui précède et représenté sur les dessins les caractéristiques essentielles de la présente invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de formation d'un masque sur un substrat caractérisé en ce qu'il comporte les étapes suivantes:

a) la formation sur ledit substrat, d'une première couche de masquage (28) à partir d'une résine sensible à des radiations de longueurs d'onde inférieures à environ 260 nm,

b) la formation sur cette première couche de masquage (28) d'une seconde couche (12) selon une configuration désirée, à partir d'une résine sensible opaque à des radiations de longueurs d'onde inférieures à environ 300 nm, pour constituer un masque intermédiaire,

c) transfert de la configuration du masque intermédiaire (12) sur la première couche de masquage (28) par exposition à des radiations, dont au moins une longueur d'onde est inférieure à 300 nm, et

d) élimination des parties exposées (30) de la première couche de masquage (28) à l'aide d'un solvant approprié pour constituer un masque.

2. Procédé de formation d'un masque selon la revendication 1 caractérisé en ce qu'il comporte en outre l'étape:

e) élimination dudit masque intermédiaire.

3. Procédé de formation d'un masque selon la revendication 1 ou 2 caractérisé en ce que la résine sensible de l'étape b) est du type phénol-formaldéhyde sensibilisé par un composé diazoïque.

4. Procédé de formation d'un masque selon la revendication 3 caractérisé en ce que le phénol formaldéhyde est soluble dans les bases sensibilisée par un ester de l'acide naphto-quinone-(1,2)-diazide sulfonique.

5. Procédé de formation d'un masque selon l'une des revendications 1 à 4, caractérisé en ce que la résine sensible de l'étape a) est un polymère de méthacrylate d'alkyle.

6. Procédé de formation d'un masque selon la revendication 5 caractérisé en ce que le polymère de méthacrylate d'alkyle comprend au moins en partie du polyméthacrylate de méthyle.

7. Procédé de formation d'un masque selon l'une des revendications ci-dessus, caractérisé en ce que les radiations de l'étape c) sont comprises dans la gamme allant de 200 à 260 nm.

8. Procédé de formation d'un masque selon l'une des revendications ci-dessus, caractérisé en ce que la radiation utilisée pour exposer ladite seconde couche (12) selon une configuration désirée est choisie dans le groupe comprenant un faisceau électronique commandé par calculateur et une lumière ayant une longueur d'onde comprise entre 300 et 450 nm.

9. Procédé de formation d'un masque selon l'une des revendications ci-dessus, caractérisé en ce que ladite seconde couche (12) est plus mince que ladite première couche.

10. Procédé de formation d'un masque selon la revendication 9 caractérisé en ce que le rapport des épaisseurs de la première couche et de la seconde couche est 2 ou 8.

11. Procédé de formation d'un masque selon la revendication 10 caractérisé en ce que ladite première couche a une épaisseur d'environ 1,6 $\mu$m et que ladite seconde couche a une épaisseur de 0,2 ou 0,8 $\mu$m.

**Patentansprüche**

1. Verfahren der Bildung einer Maske auf einem Substrat, dadurch gekennzeichnet, dass es folgende Schritte enthält:

a) Die Bildung einer ersten Abdeckschicht (28) auf dem besagten Substrat mit Hilfe eines Harzes, das auf Strahlungen anspricht, deren Wellenlänge ca. 260 nm unterschreitet;

b) die Bildung einer zweiten Schicht (12) auf dieser ersten Abdeckschicht (28) nach einer gewünschten Anordnung, mit Hilfe eines lichtundurchlässigen Harzes, das auf Strahlungen anspricht, deren Wellenlänge ca. 300 nm unterschreitet, um eine Zwischenmaske zu bilden,

c) Übertragung der Anordnung der Zwischenmaske (12) auf die ersten Abdeckschicht (28) durch Bestrahlung mit Strahlen, due mindestens eine Wellenlänge unter 300 nm enthalten, und

d) Ausscheidung der belichteten Teile (30) der ersten Abdeckschicht (28) mit Hilfe eines geeigneten Lösemittels, um eine Maske zu bilden.

2. Verfahren der Bildung einer Abdeckschicht gemäss Anspruch 1, dadurch gekennzeichnet, dass es zusätzlich die folgende Stufe enthält:

e) Ausscheidung der besagten Zwischenmaske.

3. Verfahren der Bildung einer Maske gemäss Anspruch 1 oder 2, dadurch gekennzeichnet, dass das lichtempfindliche Harz der Stufe b) vom Typ Phenol-Formaldehyd ist, das durch eine diazoïsche Verbindung empfindlich gemacht wurde.

4. Verfahren der Bildung einer Maske gemäss Anspruch 3, dadurch gekennzeichnet, dass das Formaldehyd-Phenol in Basen löslich ist, welche durch einen Ester sulfonischer Naphtoquinin-(1,2)-Diazidsäure lichtempfindlich gemacht wird.

5. Verfahren der Bildung einer Maske nach einem der Ansprüche 1 bis 4, dadurch gekennzeichnet, dass das lichtempfindliche Harz der Stufe a) ein Alkyl-Methacrylat-Polymer ist.

6. Verfahren der Bildung einer Maske nach Anspruch 5, dadurch gekennzeichnet, dass das Alkyl-Methacrylat-Polymer mindestens zum Teil Methyl-Polymethacrylat enthält.

7. Verfahren der Bildung einer Maske nach einem der oben genannten Ansprüche, dadurch gekennzeichnet, dass die Strahlunge nder Stufe c) in einem Bereich von 200 bis 260 nm liegen.

8. Verfahren der Bildung einer Maske nach einem der oben genannten Ansprüche, dadurch gekennzeichnet, dass die Strahlung, die verwendet wird, um die besagte zweite Schicht (12) nach einer bestimmten Anordnung zu belichten, in einer Gruppe gewählt wird, welche einen computergesteuerten Elektronikstrahl und ein Licht mit einer Wellenlänge von 300 bis 450 nm enthält.

9. Verfahren der Bildung einer Maske gemäss einem der oben genannten Ansprüche, dadurch gekennzeichnet, dass die besagte zweite Schicht (12) dünner als die besagte erste Schicht ist.

10. Verfahren der Bildung einer Maske gemäss Anspruch 9, dadurch gekennzeichnet, dass das Stärkenverhältnis der ersten Schicht und der zweiten Schicht 2 zu 8 beträgt.

11. Verfahren der Bildung einer Maske gemäss Anspruch 10, dadurch gekennzeichnet, dass die besagte erste Schicht eine Stärke von ca. 1,6 $\mu$ aufweist, und dass die besagte zweite Schicht eine Stärke von 0,2 oder 0,8 $\mu$ aufweist.

**Claims**

1. A method of forming a mask on a substrate characterized in that it comprises the following steps:

a) forming a first masking layer (28) on said substrate from a resist which is sensitive to radiation having wavelength components below about 260 nm,

b) forming a second layer (12) on said first masking layer (28) in accordance with a desired pattern, from a resist which is opaque to radiation having wavelength components below about 300 nm for providing an intermediate mask,

c) transferring intermediate mask pattern (12) on first masking layer (28) by exposition to radiation at least one wavelength component of which is below 300 nm, and

d) removing exposed portions (30) of first masking layer (28) by using an appropriate solvent for forming a mask.

2. A method according to claim 1 characterized it further comprises the following step:

e) removing said intermediate mask.

3. A method according to claim 1 or 2 characterized in that said resist of step b) is of the diazo sensitized phenol-formaldehyde type.

4. A method according to claim 3 characterized in that the phenol-formaldehyde is soluble into the naphthoquinone-(1,2)-diazide sulfonic acid ester sensitized bases.

5. A method according to any one of claims 1 to 4 characterized in that the resist of step a) is an alkyl methacrylate polymer.

6. A method according to claim 5 characterized in the alkyl methacrylate polymer comprises at least a part of polymethyl methacrylate.

7. A method according to any one of the above claims characterized in that the radiation of step c) has wavelength component between 200 and 260 nm.

8. A method according to any one of the above claims characterized in that the radiation used for exposing said second layer (12) in accordance with a desired pattern, is chosen from the group comprising a computer controlled electronic beam and a light having a wavelength between 300 and 450 nm.

9. A method according to any one of the above claims characterized in that said second layer (12) is thinner than said first layer.

10. A method according to claim 9 characterized in that the first layer/second layer thickness ratio is of 2 or 8.

11. A method according to claim 10 characterized in that said first layer is about 1,6 $\mu$m thick and said second layer is 0,2 or 0,8 $\mu$m thick.

0 002 999

FIG. 1A

FIG. 1C

FIG. 1B

1

0 002 999

FIG. 2

FIG. 3A

FIG.3B

FIG. 3C

2